# EUROPEAN PATENT APPLICATION

(11) **EP 4 258 368 A1**
(43) Date of publication of application: **11.10.2023**
(21) Application number: 23165083.9
(22) Date of filing: 29.03.2023
(51) Int. Cl.: H01L 33/48, H01L 33/50, H01L 33/44, H01L 33/00

(54) **PHOSPHOR MEMBER, METHOD OF MANUFACTURING PHOSPHOR MEMBER, AND LIGHT-EMITTING DEVICE**

(30) Priority: 31.03.2022 JP 2022057782; 02.10.2022 JP 2022159172
(71) Applicant: Nichia Corporation, Anan-shi, Tokushima 774-8601 (JP)
(72) Inventor: MIURA, Soichiro, Anan-shi, 774-8601 (JP); ETO, Kazuya, Anan-shi, 774-8601 (JP)
(74) Representative: Betten & Resch

(57) **Abstract**

A phosphor member disclosed in one embodiment includes: a phosphor portion including a first surface and a second surface; and a surrounding portion connected to an outer edge of the first surface and connected to an outer edge of the second surface. In a plan view viewed in a direction perpendicular to the first surface, the first surface has a shape including a first region with a width in a second direction perpendicular to a first direction, the width in the second direction increasing along the first direction. A maximum width of the second surface in the second direction is greater than a minimum width of the first surface in the second direction and less than a maximum width of the first surface in the second direction.

## Description

### CROSS-REFERENCE TO RELATED APPLICATIONS

This application claims priority to Japanese Patent Application No. 2022-057782, filed on March 31, 2022, and Japanese Patent Application No. 2022-159172, filed on October 2, 2022. The disclosures of these applications are hereby incorporated by reference in their entireties.

### BACKGROUND

The present disclosure relates to a phosphor member, a method of manufacturing a phosphor member, and a light-emitting device including a phosphor member.

In Japanese Patent Application Publication No. 2019-9406 A, an optical component is described that includes a light-transmissive member including a phosphor and a light-reflective member provided at a side surrounding the light-transmissive member. Also, a configuration of a light-emitting device is described in which the light from a light-emitting element is incident on the light-transmissive member.

### SUMMARY

Provided is a phosphor member that can be installed in a light-emitting device and can efficiently emit light.

According to one embodiment, a phosphor member includes: a phosphor portion including a first surface and a second surface; and a surrounding portion connected to an outer edge of the first surface and connected to an outer edge of the second surface. In a plan view viewed in a direction perpendicular to the first surface, the first surface has a shape including a first region with a width in a second direction perpendicular to a first direction, the width in the second direction increasing along the first direction. A maximum width of the second surface in the second direction is greater than a minimum width of the first surface in the second direction and less than a maximum width of the first surface in the second direction.

According to another embodiment, a method is provided for manufacturing a phosphor member including a first surface, a second surface, and a third surface opposite to the first surface. The method includes providing a base material, base material includes a plurality of phosphor portions, each including the third surface with a shape including a region having a width in a second direction perpendicular to a first direction, the width in the second direction increasing along the first direction, and a surrounding portion that surrounds an outer perimeter of the third surface of each of the plurality of phosphor portions; cutting the base material in a direction from the third surface toward the first surface to a position that does not reach the first surface, the cutting performed, in a plan view viewed in a direction perpendicular to the third surface, along a straight line that is parallel with the second direction and passes along a width of the region in the second direction greater than a minimum width of the region in the second direction and less than a maximum width of the region in the second direction, to obtain the second surface of each of the plurality of phosphor portions; and cutting only the surrounding portion of the base material to singulate into the plurality of phosphor portions.

According to another embodiment, a light-emitting device includes: a light-emitting element; the phosphor member described above; and a package forming an internal space where the light-emitting element and the phosphor member are disposed. Light emitted from the light-emitting element is incident on the second surface of the phosphor member. Light emitted from the first surface of the phosphor member is emitted toward the outside of the package.

According to certain embodiments of the disclosure, a phosphor member that can be installed in a light-emitting device and that can efficiently emit light can be provided.

### BRIEF DESCRIPTION OF DRAWINGS

FIG. 1 is a schematic perspective view of a light-emitting device according to some embodiments.
FIG. 2 is a schematic perspective view of the light-emitting device according to a first embodiment, in a state in which a cover member is removed.
FIG. 3 is a schematic top view of the state in FIG. 2.
FIG. 4 is a schematic cross-sectional view taken along cross section line IV-IV in FIG. 1.
FIG. 5 is a schematic perspective view of a phosphor member according to some embodiments as seen from above.
FIG. 6 is a schematic perspective view of the phosphor member according to some embodiments as seen from below.
FIG. 7 is a schematic top view of the phosphor member according to some embodiments.
FIG. 8 is a schematic bottom view of the phosphor member according to some embodiments.
FIG. 9 is a schematic side view of the phosphor member according to some embodiments as seen from an incident surface side.
FIG. 10 is a schematic perspective view of a phosphor portion according to some embodiments.
FIG. 11 is a schematic perspective view of a surrounding portion according to some embodiments.
FIG. 12A is a schematic diagram for describing a first step of a method of manufacturing the phosphor member according to some embodiments.
FIG. 12B is a schematic diagram for describing a second step of the method of manufacturing the phosphor member according to some embodiments.
FIG. 12C is a schematic diagram for describing a third step of the method of manufacturing the phosphor member according to some embodiments.
FIG. 13 is a schematic top view of a light-emitting device according to a second embodiment, in the state in which the cover member is removed.
FIG. 14 is a schematic cross-sectional view taken along cross section line XIV-XIV in FIG. 1.

### DETAILED DESCRIPTION

In the present specification and claims, the term "polygonal shape," such as a triangle, quadrangle, or the like, includes shapes with modifications such as rounded, beveled, angled, or reverse-rounded corners. Similarly, not only shapes with such modifications at corners (ends of sides) but also shapes with modifications at intermediate portions of sides will be similarly referred to as polygonal shapes. In other words, a polygon-based shape with a partial modification is included in the term "polygonal shape" disclosed in the present specification and the claims.

The same applies not only to polygons but also to terms representing specific shapes such as trapezoids, circles, protrusions, and recesses. Furthermore, the same applies when describing each side forming that shape. That is, even if an end or an intermediate portion of a side is modified, the modified portion is interpreted as a portion of the "side." When "polygonal shapes" and "sides" without such modification are to be distinguished from those with modifications, the term "in a strict sense" may be added, and may be referred to as terms such as "a quadrangular shape in a strict sense."

Furthermore, in the specification and the claims, descriptions such as upper and lower (upward/downward), left and right, top and bottom, front and back (forward/backward), near and far, and the like are used merely to describe the relative relationship of positions, orientations, directions, and the like, and the expressions need not correspond to an actual relationship at the time of use.

In the drawings, directions such as an X direction, a Y direction, and a Z direction may be indicated by using arrows. The directions of the arrows are the same across multiple drawings of the same embodiment. In addition, in the drawings, the directions of the arrows marked with an X, Y, and Z indicate respective positive directions, and directions opposite to these directions indicate respective negative directions. For example, the direction marked with "X" at the tip of the arrow indicates the X direction and the positive direction. The direction which is the X direction and the positive direction may be referred to as the +X direction and the opposite direction may be referred to as the -X direction. The same applies to the Y direction and Z direction.

Further, "member," "portion," etc., may be described when, for example, a component and the like are described in this specification. The term "member" refers to an object to be treated as a physically single component. The object to be treated as a physically single component can also be an object treated as a single component in a manufacturing process. On the other hand, the term "portion" refers to an object that need not be treated as a physically single component. For example, the term "portion" is used when a portion of a single member is partially regarded.

Note that the distinction between "member" and "portion" described above does not indicate an intention to limit the scope of rights in interpretation of the doctrine of equivalents. In other words, even when there is a component described as "member" in the claims, this does not mean that the applicant recognizes that treating the component as a physically single component is essential in the application of the present invention.

Furthermore, in the specification and the claims, when there are a plurality of components and each of these components is to be indicated separately, the components may be distinguished by adding the terms "first" and "second" before the name of the component. Further, objects to be distinguished may differ between the specification and the claims. Thus, there may be a case in which, although a component in the claims is given the same term as that in the specification, the object indicated by that component is not the same between the specification and the claims.

For example, when there are components distinguished by using "first," "second," and "third" in the specification, and when components given the terms "first" and "third" in the specification are described in the claims, these components may be distinguished by being denoted as "first" and "second" in the claims for ease of understanding. In this case, the components denoted as "first" and "second" in the claims refer to the components termed "first" and "third" in the specification, respectively. Such denotations is not limited to components and may also apply to other objects in a reasonable and flexible manner.

Certain embodiments of the present invention will be described below. Furthermore, specific embodiments of the present invention will be described below with reference to the drawings. Embodiments of the present invention are not limited to the specific embodiments to be described below. In other words, the illustrated embodiments are not an only form in which the present invention is realized. Sizes, positional relationships, and the like of members illustrated in the drawings may be exaggerated in order to facilitate understanding.

### First Embodiment

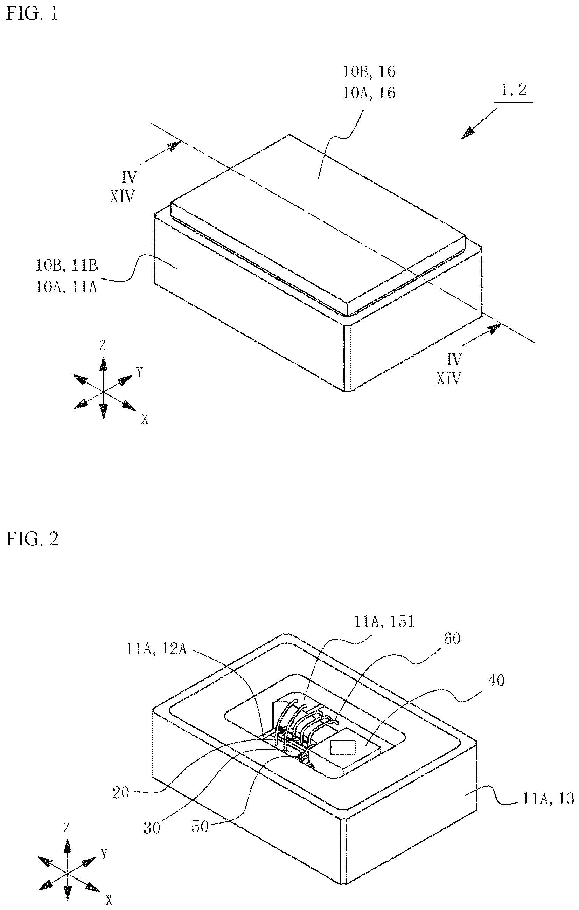

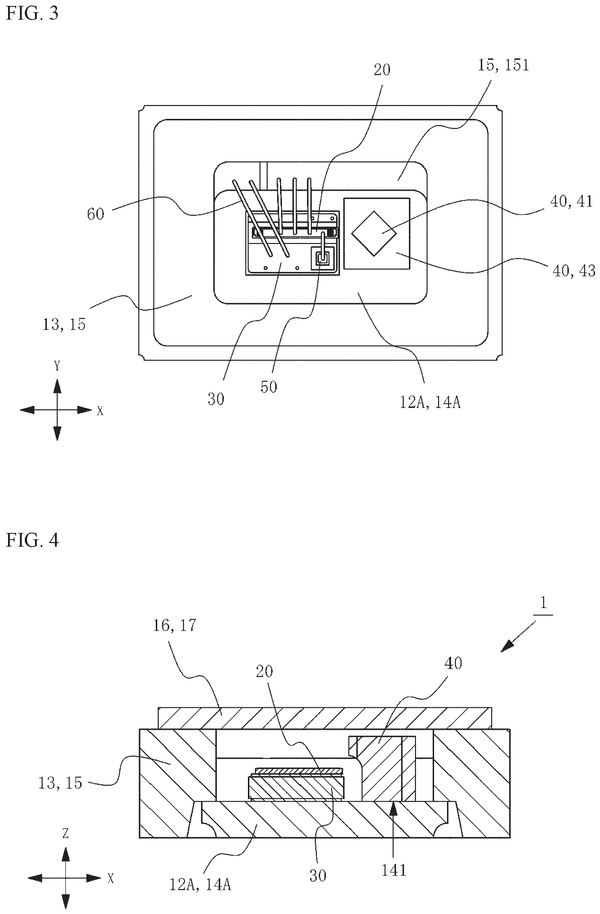

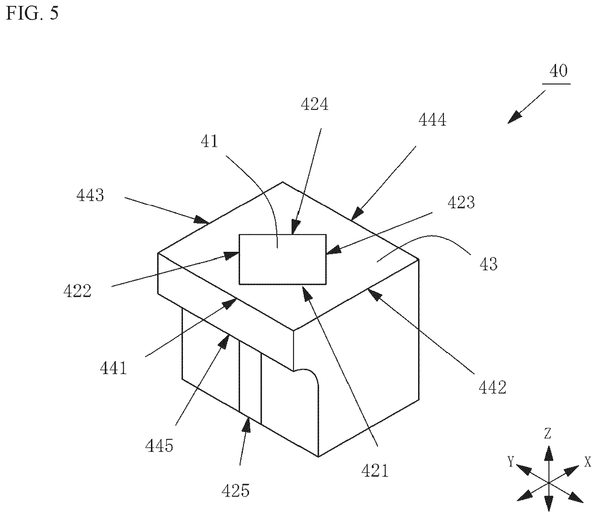

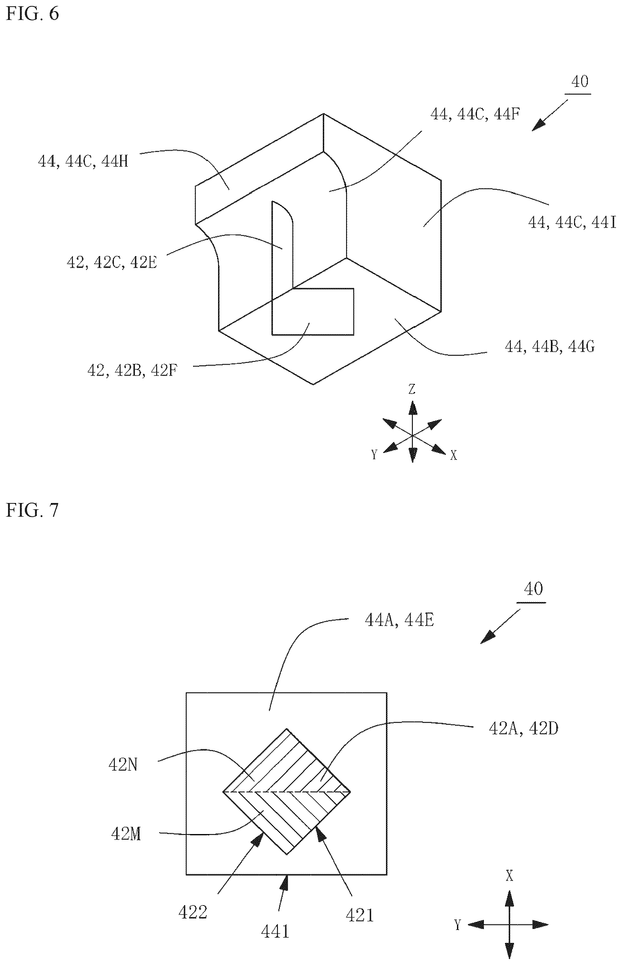

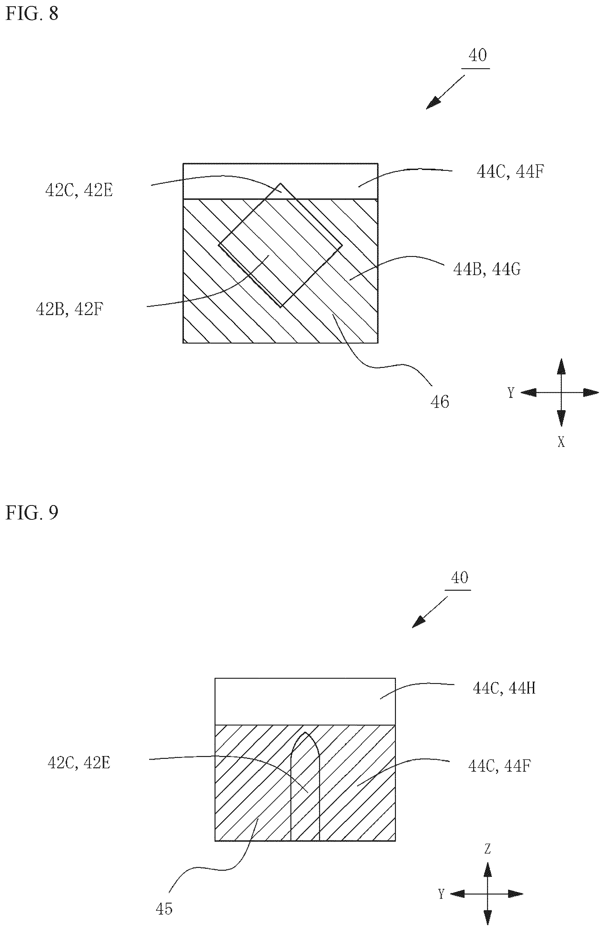

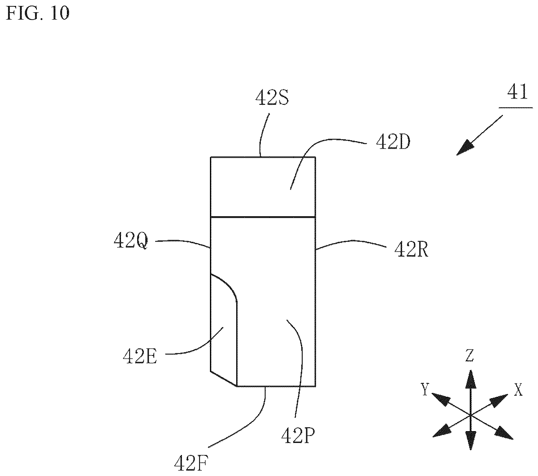

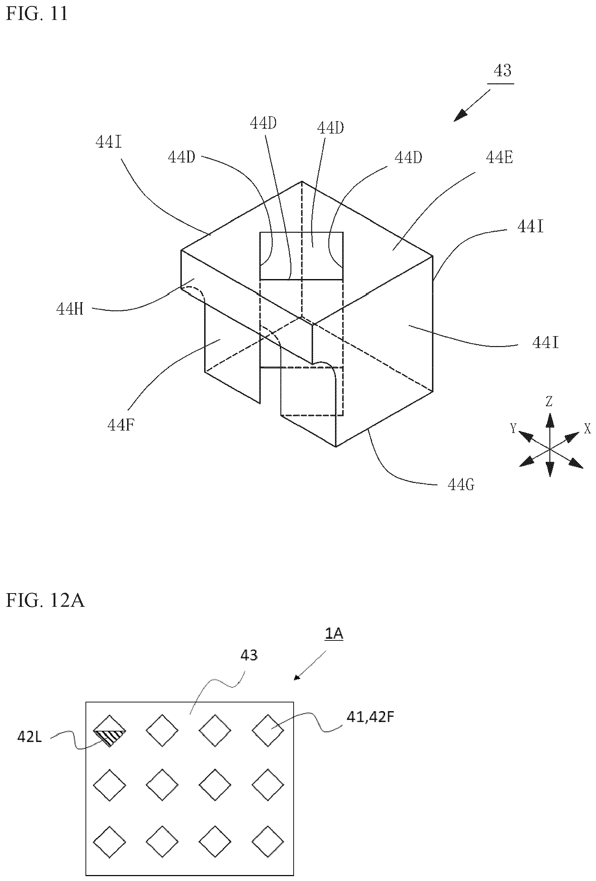

A light-emitting device 1 according to a first embodiment will now be described. FIGS. 1 to 11 are drawings for explaining an exemplary form of the light-emitting device 1. FIG. 1 is a schematic perspective view of the light-emitting device 1. FIG. 2 is a schematic perspective view of the light-emitting device 1, in a state in which a cover member 16 is removed. FIG. 3 is a schematic top view of the light-emitting device 1, in a state in which the cover member 16 is removed. FIG. 4 is a schematic cross-sectional view taken along cross section line IV-IV in FIG. 1. FIG. 5 is a schematic perspective view of a phosphor member 40 as seen from above. FIG. 6 is a schematic perspective view of the phosphor member 40 as seen from below. FIG. 7 is a schematic top view of the phosphor member 40. In FIG. 7, a first region 42M and a second region 42N are indicated with hatching. FIG. 8 is a schematic bottom view of the phosphor member 40. In FIG. 8, a light-reflective film 46 is indicated with hatching. FIG. 9 is a schematic side view of the phosphor member 40 as seen from the incident surface side of the phosphor member 40. In FIG. 9, a light-controlling film 45 is indicated with hatching. FIG. 10 is a schematic perspective view of a phosphor portion 41 as seen from above. FIG. 11 is a schematic perspective view of a surrounding portion 43 as seen from above. FIG. 11 is a schematic transparent view to clearly illustrate an inner surface 44D of the surrounding portion 43.

The light-emitting device 1 includes a plurality of components. The plurality of components include a package 10A, a light-emitting element 20, a submount 30, the phosphor member 40, a protective element 50, and a plurality of wirings 60. Note that the light-emitting device 1 may include a component other than the components described above. Some of the components described above may be omitted from the light-emitting device 1.

First, each of the components will be described.

### Package 10A

The package 10A includes a base portion 14A, a frame portion 15, and a cover portion17.

Also, the package 10A includes a base member 11A and the cover member 16. The base member 11A includes the base portion 14Aand the frame portion 15, and the cover member 16 includes the cover portion17. Also, the base member 11A includes a mounting substrate 12A and a frame member 13. The mounting substrate 12A includes the base portion 14A, and the frame member 13 includes the frame portion 15.

A closed space is formed inside the package 10A. The internal space is a sealed space. Also, the internal space is a space sealed in an airtight state at a predetermined atmosphere.

The base portion 14A includes an upper surface and a lower surface. In a top view, the external shape of the base portion 14A is rectangular. This rectangular shape may be a rectangular shape with long sides and short sides. Note that the external shape of the base portion 14A in a top view need not be a rectangular shape. The term "rectangular shape" may include a square shape unless specifically described as excluding a square shape. In the illustrated package 10A, a long side direction of the rectangle is the same direction as the X direction, and a short side direction is the same direction as the Y direction.

The base portion 14A includes a first mounting surface 141. For example, the upper surface of the base portion 14A may serve as the first mounting surface 141. Other components may be mounted on the first mounting surface 141. The first mounting surface 141 may serve as a placement region where the other components are disposed.

The frame portion 15 includes one or a plurality of inner surfaces and one or a plurality of outer surfaces. The inner surface of the frame portion 15 meets the upper surface of the base portion 14A and extends upward from the upper surface of the base portion 14A. The frame portion 15 forms a frame surrounding the upper surface of the base portion 14A in a top view. The frame portion 15 forms a rectangular frame in a top view. This rectangular shape may be a rectangular shape with long sides and short sides. In the illustrated package 10A, a long side direction of the rectangle is the same direction as the X direction, and a short side direction is the same direction as the Y direction.

The frame portion 15 includes a stepped portion 151. In the example herein, only an upper surface and lateral surface that meet the upper surface and extend downward define the stepped portion 151. That is, a lateral surface that meets the upper surface and extends upward is not included in surfaces that define the stepped portion 151. In a top view, the stepped portion 151 is provided inward of the frame defined by the outer surface of the frame portion 15. The lateral surface of the stepped portion 151 may serve as the inner surface of the frame portion 15. The frame portion 15 includes an inner surface serving as a lateral surface of the stepped portion 151 and an inner surface serving as a lateral surface that meets the upper surface of the stepped portion 151 and extends upward. The lateral surface of the stepped portion 151 meets the first mounting surface 141.

The stepped portion 151 is provided along the frame formed by the frame portion 15. In the example herein, the stepped portion 151 is not provided along the entire perimeter of the frame and is provided partially along the frame. The stepped portion 13 may be provided along the entire perimeter of the frame. The stepped portion 151 is provided along one side of the rectangular frame of the frame portion 15. This side is a long side of the frame.

One or a plurality of metal films may be provided on the upper surface of the stepped portion 151. The metal film provided on the upper surface of the stepped portion 151 is electrically connected to the metal film provided on the outer surface of the package 10 A.

The cover portion17 includes an upper surface and a lower surface. The lower surface of the cover portion17 faces the upper surface of the base portion 14A. The cover portion17 transmits light having a predetermined wavelength. The cover portion17 has light transmittance from the lower surface to the upper surface. As used herein, having transmissivity with respect to light having a predetermined wavelength means having transmittance of 80% or greater with respect to light having the predetermined wavelength.

The internal space of the package 10A is defined by the upper surface of the base portion 14A, the inner surface of the frame portion 15, and the lower surface of the cover portion 17.

The base member 11A includes the first upper surface and a second upper surface located above the first upper surface. The second upper surface surrounds the first upper surface in a top view. A recessed shape is formed in the base member 11A. The first upper surface is the upper surface of the base portion 14A. The second upper surface meets the outer surface and the inner surface of the frame portion. The base member 11A further includes a third upper surface located above the first upper surface and below the second upper surface. The third upper surface is the upper surface of the stepped portion 151.

The mounting substrate 12A is formed in a flat plate-like shape. In a top view, the mounting substrate 12A is located inward of the outer edge of the frame portion 15. At the peripheral edge region of the upper surface of the mounting substrate 12A, the mounting substrate 12A is joined to the frame member 13. The cover member 16 is formed in a flat plate-like shape. In a top view, the cover member 16 has an outer edge shape larger than that of the mounting substrate 12A.

The main material of the mounting substrate 12Ais a metal or a composite containing a metal. For example, the main material of the mounting substrate 12Ais copper. The main material of the frame member 13 is a ceramic. For example, the main material of the frame member 13 is either aluminum nitride, silicon nitride, or aluminum oxide. The main material of the cover member 16 is either quartz, silicon carbide, sapphire, or glass, for example. For the metal film of the stepped portion 151, Ni/Au (metal film laminated in order of Ni, Au), Ti/Pt/Au (metal film laminated in order of Ti, Pt, Au), and the like can be used.

Here, the main material refers to a material that occupies the greatest ratio of a target formed product in terms of weight or volume. Note that, when a target formed product is formed of one material, that material is the main material. In other words, when a certain material is the main material, the percentage of that material may be 100%.

The mounting substrate 12A and the frame member 13 may be a base member 11A formed integrally with the same material. When the mounting substrate 12A is made of metal, the base member 11A is given excellent heat dissipation, but the base member 11A is not limited thereto.

The stepped portion 151 may be included in the base portion 14A instead of being included in the frame portion 15. By forming the stepped portion 151 integrally with the frame portion 15, the size of the package 10A can be reduced, but the package 10A is not limited thereto.

### Light-Emitting Element 20

The light-emitting element 20 includes a light-emitting surface that emits light. The light-emitting element 20 includes an upper surface, a lower surface, and a plurality of lateral surfaces. The lateral surface of the light-emitting element 20 is the light-emitting surface. The light-emitting element 20 includes one or a plurality of light-emitting surfaces.

A shape of the upper surface of the light-emitting element 20 is a rectangular shape having long sides and short sides. Note that the shape of the upper surface of the light-emitting element 20 may be other than rectangular. A semiconductor laser element can be employed for the light-emitting element 20. Note that the light-emitting element 20 is not limited to a semiconductor laser element, and a light-emitting diode or the like may be employed.

As the light-emitting element 20, for example, a light-emitting element that emits blue light, a light-emitting element that emits green light, or a light-emitting element that emits red light can be employed. Note that a light-emitting element that emits light of another color may be employed as the light-emitting element 20.

Blue light refers to light having a light emission peak wavelength within a range from 420 nm to 494 nm. Green light refers to light having a light emission peak wavelength within a range from 495 nm to 570 nm. Red light refers to light having a light emission peak wavelength within a range from 605 nm to 750 nm.

For example, light is emitted from the light-emitting element 20 with a light emission peak wavelength in a range from 320 nm to 530 nm and typically in a range from 430 nm to 480 nm.

Here, a semiconductor laser element being an example of the light-emitting element 20 will be described. The semiconductor laser element has a rectangular external shape having one set of opposite sides as long sides and another set of opposite sides as short sides in a top view. Light (a laser beam) emitted from the semiconductor laser element spreads. Further, divergent light is emitted from an emission end surface of the semiconductor laser element. The emission end surface of the semiconductor laser element can be referred to as the light-emitting surface of the light-emitting element 20.

The light emitted from the semiconductor laser element forms a far field pattern (hereinafter referred to as an "FFP") of an elliptical shape in a plane parallel to the emission end surface of the light. The FFP indicates a shape and a light intensity distribution of the emitted light at a position separated from the emission end surface.

Here, light passing through the center of the elliptical shape of the FFP, in other words, light having a peak intensity in the light intensity distribution of the FFP is referred to as light traveling on an optical axis or light passing through an optical axis. Based on the light intensity distribution of the FFP, light having an intensity of 1/e² or more with respect to a peak intensity value is referred to as a main portion of the light.

The shape of the FFP of the light emitted from the semiconductor laser element is an elliptical shape in which the light in a layering direction is longer than in a direction perpendicular to the layering direction in the plane parallel to the emission end surface of the light. The layering direction is a direction in which a plurality of semiconductor layers including an active layer are layered in the semiconductor laser element. The direction perpendicular to the layering direction can also be referred to as a plane direction of the semiconductor layer. Further, a long diameter direction of the elliptical shape of the FFP can also be referred to as a fast axis direction of the semiconductor laser element, and a short diameter direction can also be referred to as a slow axis direction of the semiconductor laser element.

Based on the light intensity distribution of the FFP, an angle at which light having a light intensity of 1/e² of a peak light intensity spreads is referred to as a divergence angle of light of the semiconductor laser element. For example, a divergence angle may also be determined based on the light intensity that is half of the peak light intensity in addition to being determined based on the light intensity of 1/e² of the peak light intensity. In the description herein, the term "divergence angle" by itself refers to a divergence angle of light at the light intensity of 1/e² of the peak light intensity. Note that it can be said that a divergence angle in the fast axis direction is greater than a divergence angle in the slow axis direction.

A semiconductor laser element with a divergence angle in the slow axis direction in a range from 2 degrees to 30 degrees can be employed for the light-emitting element 20. A semiconductor laser element with a divergence angle in the fast axis direction in a range from 5 degrees to 120 degrees can be employed for the light-emitting element 20.

Examples of the semiconductor laser element that emits blue light or the semiconductor laser element that emits green light include a semiconductor laser element including a nitride semiconductor. GaN, InGaN, and AlGaN, for example, can be used as the nitride semiconductor. Examples of the semiconductor laser element that emits red light include a semiconductor laser element including an InAlGaP-based, GaInP-based, GaAs-based, or AlGaAs-based semiconductor.

### Submount 30

The submount 30 includes an upper surface and a lower surface. The submount 30 is formed in a rectangular parallelepiped shape. In a top view, the submount 30 has a rectangular external shape with long sides and short sides. The submount 30 has the smallest width in a vertical direction. The width of the submount 30 in the vertical direction may be in a range from 50 µm to 1000 µm. Note that the shape of the submount 30 is not limited to the rectangular parallelepiped shape. The submount 30 may be formed using, for example, silicon nitride, aluminum nitride, or silicon carbide. Further, a metal film for bonding is provided on the bonding surface.

### Phosphor Member 40

The phosphor member 40 includes the phosphor portion 41 and the surrounding portion 43. The surface of the phosphor member 40 includes a surface of the phosphor portion 41 and a surface of the surrounding portion 43. In the phosphor member 40, a portion of the phosphor portion 41 is exposed and other portions are surrounded by the surrounding portion 43. The surrounding portion 43 is provided on a surface other than the exposed surface of the phosphor portion 41.

Further, the phosphor member 40 may include the light-controlling film 45. Also, the phosphor member 40 may include the light-reflective film 46.

The phosphor portion 41 includes a plurality of surfaces 42. The plurality of surfaces 42 include an upper surface 42A, a lower surface 42B, and a plurality of lateral surfaces 42C. The upper surface 42A is exposed in the phosphor member 40. The plurality of lateral surfaces 42C include the lateral surface 42C exposed from the surrounding portion 43 in the phosphor member 40 and the lateral surface 42C that is not exposed from the surrounding portion 43 in the phosphor member 40. The lateral surface 42C that is not exposed from the surrounding portion 43 in the phosphor member 40 comes into contact with the surrounding portion 43.

The plurality of surfaces 42 include a first surface 42D and a second surface 42E. The first surface 42D and the second surface 42E are each exposed in the phosphor member 40. In other words, the first surface 42D and the second surface 42E are not included in the surfaces of the phosphor portion 41 on which the surrounding portion 43 is provided. The first surface 42D and the second surface 42E are not parallel. For example, the upper surface 42A of the phosphor portion 41 may serve as the first surface 42D, and the lateral surface 42C of the phosphor portion 41 may serve as the second surface 42E. The plurality of surfaces 42 include a third surface 42F, which is a surface on the opposite side to the first surface 42D. The second surface 42E meets the third surface 42F.

The plurality of surfaces 42 include a fourth surface 42P and a fifth surface 42Q that meet the third surface 42F. The fourth surface 42P and the fifth surface 42Q are each not exposed in the phosphor member 40. Also, the plurality of surfaces 42 include a sixth surface 42R and a seventh surface 42S that meet the third surface 42F. The sixth surface 42R and the seventh surface 42S are each not exposed in the phosphor member 40.

The fourth surface 42P and the fifth surface 42Q meet the second surface 42E. The fourth surface 42P and the fifth surface 42Q meet the first surface 42D. The first surface 42D does not meet the second surface 42E. The first surface 42D meets the fourth surface 42P and the fifth surface 42Q. The first surface 42D meets the sixth surface 42R and the seventh surface 42S. The fourth surface 42P, the fifth surface 42Q, the sixth surface 42R, and the seventh surface 42S are flat surfaces perpendicular to the first surface 42D. Note that these may be oriented other than perpendicular to the first surface 42D, or may be other than flat surfaces.

The surrounding portion 43 is connected to the outer edge of the first surface 42D of the phosphor portion 41. The surrounding portion 43 is connected to the outer edge of the second surface 42E of the phosphor portion 41. The surrounding portion 43 is connected to the outer edge of the third surface 42F of the phosphor portion 41. The surrounding portion 43 comes into contact with the fourth surface 42P and the fifth surface 42Q of the phosphor portion 41. The surrounding portion 43 comes into contact with the sixth surface 42R and the seventh surface 42S of the phosphor portion 41.

The surrounding portion 43 includes a plurality of surfaces 44. The plurality of surfaces 44 include an upper surface 44A, a lower surface 44B, an outer surface 44C, and the inner surface 44D. Further, the plurality of surfaces 44 include a plurality of outer surfaces 44C and a plurality of inner surfaces 44D. In the phosphor member 40, the upper surface 44A and the outer surface 44C are exposed. In the phosphor member 40, the inner surface 44D comes into contact with the phosphor portion 41.

The plurality of outer surfaces 44C include a first surface 44E that is connected to an outer edge of the first surface 42D of the phosphor portion 41 and extends in the same plane direction as the first surface 42D. The first surface 44E of the surrounding portion 43 surrounds the first surface 42D of the phosphor portion 41. The plurality of surfaces 44 include a second surface 44F that is connected to an outer edge of the second surface 42E of the phosphor portion 41 and extends in the same plane direction as the second surface 42E.

The plurality of outer surfaces 44C include a third surface 44G, which is a surface on the opposite side to the first surface 44E. The third surface 44G of the surrounding portion 43 is connected to the outer edge of the third surface 42F of the phosphor portion 41 and extends in the same plane direction as the third surface 42F.

The plurality of outer surfaces 44C include a fourth surface 44H that meets the first surface 44E and the second surface 44F of the surrounding portion 43. The fourth surface 44H of the surrounding portion 43 is located closer to the first surface 44E of the surrounding portion 43 than the second surface 42E of the phosphor portion 41. The fourth surface 44H of the surrounding portion 43 is not connected to the second surface 42E of the phosphor portion 41. The plurality of outer surfaces 44C include one or a plurality of fifth surfaces 44I that meet the first surface 44E and the third surface 44G of the surrounding portion 43.

In the illustrated phosphor member 40, the one or plurality of fifth surfaces 44I include two fifth surfaces 44I that each meet the second surface 44F and the fourth surface 44H of the surrounding portion 43 and another fifth surface 44I that meets the two fifth surfaces 44I.

The plurality of inner surfaces 44D come into contact with the fourth surface 42P and the fifth surface 42Q of the phosphor portion 41. The inner surface 44D that comes into contact with the fourth surface 42P and the inner surface 44D that comes into contact with the fifth surface 42Q are each connected to the outer edge of the first surface 42D of the phosphor portion 41. Furthermore, the inner surface 44D is also connected to the outer edge of the third surface 42F of the phosphor portion 41.

The plurality of inner surfaces 44D come into contact with the sixth surface 42R and the seventh surface 42S of the phosphor portion 41. The inner surface 44D that comes into contact with the sixth surface 42R and the inner surface 44D that comes into contact with the seventh surface 42S are each connected to the outer edge of the first surface 42D of the phosphor portion 41. Furthermore, the inner surface 44D is also connected to the outer edge of the third surface 42F of the phosphor portion 41.

The inner surface 44D that comes into contact with the fourth surface 42P of the phosphor portion 41 is connected to the outer edge of the second surface 42E of the phosphor portion 41. The inner surface 44D that comes into contact with the fifth surface 42Q of the phosphor portion 41 is connected to the outer edge of the second surface 42E of the phosphor portion 41. The inner surface 44D that comes into contact with the sixth surface 42R of the phosphor portion 41 is not connected to the outer edge of the second surface 42E of the phosphor portion 41. The inner surface 44D that comes into contact with the seventh surface 42S of the phosphor portion 41 is not connected to the outer edge of the second surface 42E of the phosphor portion 41.

The first surface 42D of the phosphor portion 41 includes the first region 42M in which, in a plan view perpendicular to the first surface 42D, the width in a second direction perpendicular to the first direction increases toward the first direction. The first surface 42D of the phosphor portion 41 includes the second region 42N in which, in a plan view perpendicular to the first surface 42D, the width in the second direction decreases toward the first direction. The second region 42N is located further to the first direction than the first region 42M. In the illustrated phosphor member 40, the first direction is the same direction as the +X direction, and the second direction is the same direction as the Y direction. Also, a third direction perpendicular to the first direction and the second direction is the same as the Z direction.

The first surface 42D of the phosphor portion 41 includes a first side 421 and a second side 422, and the first side 421 and the second side 422 form the first region 42M. The first surface 42D of the phosphor portion 41 includes a third side 423 and a fourth side 424, and the third side 423 and the fourth side 424 form the second region 42N. The first surface 42D of the phosphor portion 41 has a quadrangular shape. In one example, the first surface 42D of the phosphor portion 41 has a rhomboid shape. In one example, the first surface 42D of the phosphor portion 41 has a rectangular shape.

Also, the first side 421, the second side 422, the third side 423, and the fourth side 424 are each sides of a quadrilateral.

The fourth surface 42P meets the first side 421, and the fifth surface 42Q meets the second side 422. The sixth surface 42R meets the third side 423, and the seventh surface 42S meets the fourth side 424.

A virtual straight line connecting the intersection point of the first side 421 and the third side 423 and the intersection point of the second side 422 and the fourth side 424 serves as the boundary between the first region 42M and the second region 42N. The first region 42M is defined by the first side 421, the second side 422, and the virtual line. The second region 42N is defined by the third side 423, the fourth side 424, and the virtual line. The virtual line is parallel with the second direction.

The external shape of the second surface 42E of the phosphor portion 41 has an elongated shape. In a plan view as seen from the side of the second surface 42E, the length in a fourth direction parallel with the virtual line that line-symmetrically bisects the second surface 42E is greater than the length in a fifth direction perpendicular to the fourth direction. In the illustrated phosphor member 40, the fourth direction is the same direction as the Z direction, and the fifth direction is the same direction as the Y direction. The second surface 42E of the phosphor portion 41 can be said to have a shape with a greater maximum width in the third direction than the maximum width in the second direction.

The maximum width in the second direction of the second surface 42E of the phosphor portion 41 is greater than the minimum width in the second direction of the first surface 42D of the phosphor portion 41. Also, the maximum width in the second direction of the second surface 42E of the phosphor portion 41 is greater than the minimum width in the second direction of the first surface 42D of the phosphor portion 41 in the first region.

The maximum width in the second direction of the second surface 42E of the phosphor portion 41 is less than the maximum width in the second direction of the first surface 42D of the phosphor portion 41. Also, the maximum width in the second direction of the second surface 42E of the phosphor portion 41 is less than the maximum width in the second direction of the first surface 42D of the phosphor portion 41 in the first region.

The maximum width in the second direction of the second surface 42E of the phosphor portion 41 is greater than the minimum width in the second direction of the first surface 42D of the phosphor portion 41 but less than the maximum width. In the illustrated phosphor member 40, the minimum width in the second direction of the first surface 42D is the intersection point of the first side 421 and the second side 422, and thus the width is 0. Also, the maximum width in the second direction of the first surface 42D is equal to the distance from the intersection point of the first side 421 and the third side 423 to the intersection point of the second side 422 and the fourth side 424.

In a plan view perpendicular to the first surface 42D of the phosphor portion 41, the second surface 42E of the phosphor portion 41 is included in the first region 42M. In a plan view perpendicular to the first surface 42D of the phosphor portion 41, the second surface 42E of the phosphor portion 41 overlaps the first region 42M but does not overlap the second region 42N. The area of the second surface 42E of the phosphor portion 41 is less than the area of the first surface 42D of the phosphor portion 41.

The first surface 42D and the second surface 42E of the phosphor portion 41 satisfy the relationship of a virtual line perpendicular to the first surface 42D and running through the first region 42M, existing and extending through the second surface 42E of the phosphor portion 41. The distance in the third direction from the upper end of the second surface 42E of the phosphor portion 41 to the first surface 42D is less than the length in the third direction of the second surface 42E.

The area of the third surface 42F of the phosphor portion 41 is less than the area of the first surface 42D of the phosphor portion 41. As seen in a plan view viewed in a direction perpendicular to the first surface 42D of the phosphor portion 41, the third surface 42F includes a side that partially overlaps the first side 421, a side that partially overlaps the second side 422, and a fifth side 425 that overlaps a straight line connecting an intermediate point of the first side 421 and an intermediate point of the second side 422. The intermediate point of the first side 421 is at a position closer to the intersection point of the first side 421 and the second side 422 than the midpoint of the first side 421. The intermediate point of the second side 422 is at a position closer to the intersection point of the first side 421 and the second side 422 than the midpoint of the second side 422. The fifth side 425 of the phosphor portion 41 is an intersection line of the second surface 42E and the third surface 42F of the phosphor portion 41.

In a plan view perpendicular to the first surface 42D of the phosphor portion 41, the shape of the first surface 42D includes the shape of the third surface 42F. In a plan view perpendicular to the first surface 42D of the phosphor portion 41, the first region 42M includes a region overlapping the third surface 42F and a region overlapping the second surface 42E without overlapping the third surface 42F. In a plan view perpendicular to the first surface 42D of the phosphor portion 41, the second region 42N includes a region overlapping the third surface 42F and does not include a region overlapping the second surface 42E.

The first surface 44E of the surrounding portion 43 includes a first side 441 that forms a portion of the outer edge of the first surface 44E. In a plan view perpendicular to the first surface 42D of the phosphor portion 41, the first side 421 of the phosphor portion 41 is inclined with respect to the first side 441 of the surrounding portion 43. In a plan view perpendicular to the first surface 42D of the phosphor portion 41, the second side 422 of the phosphor portion 41 is inclined with respect to the first side 441 of the surrounding portion 43. In other words, being inclined means being not parallel and being not perpendicular. Also, the terms parallel and perpendicular used herein include a tolerance of a difference of ±8 degrees.

The angle of a first corner formed by a straight line passing through the first side 421 of the phosphor portion 41 and a straight line passing through the first side 441 of the surrounding portion 43 and the angle of a second corner formed by a straight line passing through the second side 422 of the phosphor portion 41 and a straight line passing through the first side 441 of the surrounding portion 43 are equal. Herein, being equal in angle includes an angle difference of 5 degrees or less. The angle of the first corner and the angle of the second corner are in a range from 10 degree to 80 degrees.

The first surface 44E of the surrounding portion 43 further includes a second side 442 and a third side 443 that forms a portion of the outer edge of the first surface 44E. Both the second side 442 and the third side 443 meet the first side 441. The angle of a first corner and the angle of a corner formed by a straight line passing through the first side 421 of the phosphor portion 41 and a straight line passing through the second side 442 of the surrounding portion 43 are equal. The angle of the second corner and the angle of a corner formed by a straight line passing through the second side 422 of the phosphor portion 41 and a straight line passing through the third side 443 of the surrounding portion 43 are equal. Herein, being equal in angle includes an angle difference of 5 degrees or less.

The first surface 44E of the surrounding portion 43 further includes a fourth side 444 that forms a portion of the outer edge of the first surface 44E. The outer edge of the first surface 44E of the surrounding portion 43 has a rectangular shape. Also, the first side 441, the second side 442, the third side 443, and the fourth side 444 are each sides of a rectangle.

In the illustrated phosphor member 40, the intersection point of the first side 421 and the second side 422 of the phosphor portion 41 is located on a line connecting a midpoint of the first side 441 and a midpoint of the fourth side 444 of the surrounding portion 43. Additionally, the intersection point of the third side 423 and the fourth side 424 of the phosphor portion 41 is located on this line. The intersection point of the first side 421 and the third side 423 of the phosphor portion 41 and the intersection point of the second side 422 and the fourth side 424 are located on a line connecting a midpoint of the second side 442 and a midpoint of the third side 443 of the surrounding portion 43.

The length of the first side 441 of the surrounding portion 43 is in a range from 2 times to 4 times the square root of the length of the first side 421 or the second side 422 of the phosphor portion 41. When the first corner and the second angle are set to 45 degrees, by making the length of the first side 441 greater than 2 times the square root of the length of the first side 421 or the second side 422, the phosphor portion 41 can be enclosed in a top view by the first surface 44E with a rectangular outer edge. Also, by making the length of the first side 441 4 times or less the square root of the length of the first side 421 or the second side 422, the size of the phosphor member 40 can be reduced.

The first side 441 of the surrounding portion 43 is an intersection line of the first surface 44E and the fourth surface 44H of the surrounding portion 43. The surrounding portion 43 includes a fifth side 445, which is an intersection line of the second surface 44F and the fourth surface 44H of the surrounding portion 43. In a plan view perpendicular to the fourth surface 44H, the area of the second surface 44F is greater than the area of the fourth surface 44H. In a plan view perpendicular to the fourth surface 44H, the fourth surface 44H of the surrounding portion 43 and the second surface 42E of the phosphor portion 41 do not overlap.

In a plan view perpendicular to the fourth surface 44H, in the fourth direction, the length of the fourth surface 44H of the surrounding portion 43 is 150% or less of the length of the second surface 44F of the surrounding portion 43. In a plan view perpendicular to the fourth surface 44H, in the fourth direction, the length of the second surface 44F of the surrounding portion 43 is greater than the length of the second surface 42E of the phosphor portion 41 and is 150% or less of the length of the second surface 42E of the phosphor portion 41.

The second surface 42E of the phosphor portion 41 and the second surface 44F of the surrounding portion 43 include a flat surface region and a curved surface region that is continuous from the flat surface region. The flat surface region forms a flat surface perpendicular to the first direction. The flat surface region of the second surface 42E meets the third surface 42F of the phosphor portion 41, and the flat surface region of the second surface 44F meets the third surface 44G of the surrounding portion 43. The curved surface region of the second surface 44F extends in a direction opposite to the first direction more than the curved surface region of the second surface 42E. The curved surface region of the second surface 44F meets the fourth surface 44H of the surrounding portion 43.

The flat surface region of the second surface 42E is surrounded by the flat surface region of the second surface 44F except for the portion connecting to the curved surface region of the second surface 42E and the third surface 42F. The curved surface region of the second surface 42E is surrounded by the curved surface region of the second surface 44F except for the portion connecting to the flat surface region of the second surface 42E. The area of the second surface 42E of the phosphor portion 41 as seen in a plan view perpendicular to the flat surface region is less than the area of the first surface 42D of the phosphor portion 41 as seen in a plan view perpendicular to the first surface 42D.

The light-controlling film 45 transmits light of a specific wavelength and reflects light of another specific wavelength. The light-controlling film 45 is provided on the second surface 42E of the phosphor portion 41. The light-controlling film 45 is provided on the entire surface of the second surface 42E of the phosphor portion 41. The light-controlling film 45 is provided on the second surface 42E of the phosphor portion 41 and on the second surface 44F of the surrounding portion 43. The light-controlling film 45 is provided on the entire surface of the second surface 44F of the surrounding portion 43.

The light-reflective film 46 reflects the light incident on the light-reflective film 46. The light-reflective film 46 reflects 90% or more of the light incident on the light-reflective film 46. The wavelength of the light reflected by the light-reflective film 46 may be restricted. For example, the light-reflective film 46 may reflect visible light. Alternatively, the light-reflective film 46 may reflect light with a wavelength in a range from 300 nm to 1000 nm. The light-reflective film 46 is provided on the third surface 42F of the phosphor portion 41. The light-reflective film 46 is provided on the entire surface of the third surface 42F of the phosphor portion 41. The light-reflective film 46 is provided on the third surface 42F of the phosphor portion 41 and on the third surface 44G of the surrounding portion 43. The light-reflective film 46 is provided on the entire surface of the third surface 44G of the surrounding portion 43.

The phosphor portion 41 includes a phosphor. Examples of the phosphor include yttrium aluminum garnet (YAG) activated with cerium, lutetium aluminum garnet (LAG) activated with cerium, silicate activated with europium ((Sr, Ba)₂SiO₄), αSiAlON phosphor, and βSiAlON phosphor. Among them, the YAG phosphor has good heat resistance.

The phosphor portion 41 is preferably formed using an inorganic material that is not easily decomposed by light irradiation as a main material. An example of the main material of the phosphor portion 41 is a ceramic, for example. Note that the main material is not limited to a ceramic. Furthermore, the phosphor portion 41 may be formed of a singlecrystal phosphor. Examples of a ceramic include, for example, aluminum oxide, aluminum nitride, silicon oxide, yttrium oxide, zirconium oxide, and magnesium oxide. The phosphor portion 41 is, for example, a sintered compact formed using a ceramic as the main material. The phosphor portion 41 can be formed by sintering, for example, a phosphor and a light-transmissive material such as aluminum oxide. The content of the phosphor can be in a range from 0.05 vol% to 50 vol% with respect to the total volume of the ceramic. Further, for example, the light transmitting portion 241 may be formed by sintering a powder of the phosphor, that is, using a ceramic substantially consisting of only the phosphor.

An example of the main material of the surrounding portion 43 is a ceramic, for example. Examples of the ceramic used for the main material include, for example, aluminum oxide, aluminum nitride, silicon oxide, yttrium oxide, zirconium oxide, and magnesium oxide. The surrounding portion 43 is, for example, a sintered compact formed using a ceramic as the main material. Note that the surrounding portion 43 may be formed using a material other than ceramic as the main material.

The phosphor member 40 can be formed by integrally forming together the phosphor portion 41 and the surrounding portion 43. For example, the phosphor member 40 can be formed by integrally sintering the phosphor portion 41 and the surrounding portion 43. The method of manufacturing the phosphor member 40 will be described below in detail.

The light-controlling film 45 can be formed of a dielectric multilayer film formed by layering a plurality of types of dielectric layers to form a multilayer film. For the dielectric layer, silicon oxide, niobium oxide, aluminum oxide, aluminum nitride, titanium oxide, tantalum oxide, or the like may be employed. These are appropriately combined to create a dielectric multilayer film according to the purpose. The light-reflective film 46 can be formed of a dielectric multilayer film using a metal, such as silver, aluminum, or the like, for example.

### Protective Element 50

The protective element 50 prevents breakage of a specific element (the light-emitting element 20, for example) as a result of an excessive current flowing through the element. The protective element 50 is a Zener diode, for example. Further, a Zener diode formed of Si can be used as the Zener diode.

### Wiring 60

The wiring 60 is a linear conductive material with joint portions at both ends. The bonded portions at both ends are joint portions with other components. The wiring 60 is, for example, a metal wire. For example, gold, aluminum, silver, copper, or the like can be used as the metal.

Subsequently, the light-emitting device 1 including the above-described components will be described.

### Light-Emitting Device 1

In the light-emitting device 1, the light-emitting element 20 is disposed in the internal space of the package 10A. The light-emitting element 20 is disposed on the base portion 14A of the package 10A. The light-emitting element 20 is disposed on the first mounting surface 141 of the base portion 14A. The light-emitting element 20 is disposed in the arrangement region of the package 10A. The light-emitting element 20 emits light that travels from the light-emitting surface toward the frame portion 15. The light-emitting element 20 emits light that travels from the light-emitting surface in the first direction.

The light-emitting element 20 is mounted on the package 10A with the submount 30 disposed therebetween. Mounting via the submount 30 allows the light emission point of the light-emitting element 20 to be located at a higher position. The light-emitting element 20 is disposed with the light-emitting surface opposing the same direction as one lateral surface of the submount 30. Further, the light-emitting surface of the light-emitting element 20 is, for example, parallel with the inner surface or the outer surface of the frame portion 15. Also, the term parallel used herein includes a tolerance of a difference of ±10 degrees.

In a top view, the light-emitting element 20 is disposed such that the long side of the light-emitting element 20 is aligned with the long side direction of the frame of the frame portion 15. As a result, the light-emitting device 1 can be reduced in size. When the submount 30 is interposed, the long side of the submount 30 is also aligned with the long side direction of the frame of the frame portion 15, which is preferable to reduce the size of the light-emitting device 1.

In the light-emitting device 1, the protective element 50 is disposed in the internal space of the package 10A. The protective element 50 is mounted on the submount 30.

The light-emitting element 20 is disposed in a region closer to the stepped portion 151 of the frame portion 15 when, in a top view, the submount 30 is divided into two equal portions by a virtual line parallel with the long side direction. On the other hand, the protective element 50 is disposed in a region farther from the stepped portion 151 of the frame portion 15. This arrangement allows the optical axis of the light emitted from the light-emitting element 20 to be close to the center in the short side direction of the light-emitting device 1.

The plurality of wirings 60 electrically connect the light-emitting element 20 to the base member 11A. The plurality of wirings 60 include a wiring 60 with two ends, the joint portion of one end joined to light-emitting element 20 and the joint portion of the other end joined to the upper surface of the stepped portion 151. Also, the plurality of wirings 60 include a wiring 60 with two ends, the joint portion of one end joined to submount 30 and the j oint portion of the other end joined to the upper surface of the stepped portion 151. This wiring is joined to the submount 30 in a region farther from the stepped portion 151 of the frame portion 15, as described above.

The wirings 60 that electrically connect the light-emitting element 20 to the base member 11A are all joined to the stepped portion 151 provided along one side of the frame of the frame portion 15. In this manner, it is sufficient to provide the stepped portion 151 only along one side of the frame of the frame portion 15, the light-emitting device 1 can be reduced in size.

In the light-emitting device 1, the phosphor member 40 is disposed in the internal space of the package 10A. The phosphor member 40 is disposed on the first mounting surface 141 of the base portion 14A. The phosphor member 40 is disposed in the arrangement region of the package 10A. The light-emitting element 20 emits light that travels from the light-emitting surface to the phosphor member 40. The light emitted from the light-emitting element 20 is incident on the phosphor portion 41 of the phosphor member 40. The phosphor member 40 is disposed at a forward position in the first direction from the light-emitting element 20. That is, it can be said that the phosphor member 40 is disposed at a position separated from the position where the light-emitting element 20 is disposed in the first direction.

The phosphor member 40 is disposed on the base portion 14A with the third surface 42F orientated opposing the upper surface of the base portion 14A. The phosphor member 40 is disposed with the second surface 42E orientated opposing the light-emitting surface of the light-emitting element 20. The light emitted from the light-emitting element 20 is incident on the second surface 42E of the phosphor member 40. The second surface 42E of the phosphor member 40 can be considered a light incident surface on which light emitted from the light-emitting element 20 is incident. A light incident surface is provided on the lateral surface of the phosphor member 40. Further, the light of the main portion emitted from the light-emitting element 20 encompasses the outer edge of the light incident surface.

The phosphor portion 41 emits fluorescence on the basis of the light that is incident from the second surface 42E of the phosphor member 40. From the first surface 42D of the phosphor member 40, light from the light-emitting element 20 or fluorescence from the phosphor portion 41 is emitted. Although only fluorescence can be emitted from the first surface 42D, white light can be emitted by combining the blue light emitted from the light-emitting element 20 and the yellow fluorescence from the phosphor together. In other words, from the first surface 42D of the phosphor member 40, both light from the light-emitting element 20 and fluorescence from the phosphor portion 41 may be emitted.

The phosphor portion 41 emits light (fluorescence) that has been converted, on the basis of the light emitted from the light-emitting element 20, to a different wavelength than the light. Note that there may be light having the same wavelength as the light emitted from the light-emitting element 20 in part of the fluorescence emitted from the phosphor portion 41. The phosphor portion 41 can be referred to as a wavelength conversion unit that emits, from the first surface 42D, light of a wavelength converted on the basis of the light emitted from the light-emitting element 20. Also, the phosphor member 40 may be referred to as a wavelength conversion member including the wavelength conversion unit.

Light is emitted upward from the first surface 42D of the phosphor member 40. The light emitted from the first surface 42D of the phosphor member 40 is emitted to the outside of the package 10A. The first surface 42D can be referred to as the light-emitting surface of the phosphor member 40. The light-emitting surface is provided on the upper surface of the phosphor member 40.

Note that the light-emitting device 1 is not limited to a configuration in which the first surface 42D is a light-emitting surface and the second surface 42E is a light incident surface. Also, the light-emitting device 1 is not limited to a configuration in which the lateral surface of the phosphor member 40 is a light incident surface and the upper surface is a light-emitting surface. For example, a lateral surface of the phosphor member 40 may be the light incident surface and another lateral surface may be the light-emitting surface.

As in the illustrated light-emitting device 1, when the second surface 42E, which is the lateral surface of the phosphor member 40, is a light incident surface and the first surface 42D, which is the upper surface, is a light-emitting surface, the first region in the first surface 42D of the phosphor member 40, in a plan view perpendicular to the first surface 42D, has a shape with a width in the second direction that increases toward the first direction from a closest point or side to the light-emitting element 20. In a plan view perpendicular to the first surface 42D, a region of at least 80% or greater of the second surface 42E is included in a region separated in a first direction from a virtual line that runs through the point or side closest to the light-emitting element 20 of the first surface 42D and parallel with the second direction. In a plan view perpendicular to the first surface 42D, a region of at least 80% or greater of the second surface 42E is included within (not including the outer edge) the outer edge of the first surface 42D. In a plan view perpendicular to the first surface 42D, a region of at least 80% or greater of the second surface 42E is included within (not including the outer edge) the first region of the first surface 42D.

The light-emitting element 20 emits light having a shape that is longer in the third direction than in the second direction as seen on a plane perpendicular to the first direction. For example, light (a laser beam) is emitted from the light-emitting element 20, which is a semiconductor laser element, with the fast axis direction of FFP being parallel with the third direction and the slow axis direction being parallel with the second direction. Also, the term parallel used in either case includes a tolerance of a difference of ±8 degrees. The light of the main portion emitted from the light-emitting element 20 has a shape that is longer in the third direction than in the second direction as seen on a plane perpendicular to the first direction.

The second surface 42E of the phosphor member 40 has a shape with a greater maximum width in the third direction than the maximum width in the second direction, and the shape of the light incident surface corresponds to the shape of the light incident on the light incident surface. As a result, light emitted from the light incident surface of the phosphor portion 41 can be reduced, and light can be efficiently emitted from the light-emitting surface of the phosphor member 40.

The maximum width in the second direction of the second surface 42E of the phosphor member 40 is 5 times or less than the length of the minor axis of the FFP of the light of the main portion incident on the second surface 42E. The maximum width in the third direction of the second surface 42E of the phosphor member 40 is 5 times or less than the length of the major axis of the FFP of the light of the main portion incident on the second surface 42E. With the shape of the light incident surface corresponding to the shape of the light incident on the light incident surface under such conditions, light can be efficiently emitted from the light-emitting surface of the phosphor member 40.

The ratio between the maximum width in the second direction of the light incident surface of the phosphor member 40 and the maximum width in the third direction is in a range from 50% to 200% of the ratio between the maximum width in the second direction of the light emitted from the light-emitting element 20 and the maximum width in the third direction. As a result, light emitted from the light incident surface of the phosphor portion 41 can be reduced, and light can be efficiently emitted from the light-emitting surface of the phosphor member 40.

In the illustrated light-emitting device 1, the third direction and the fourth direction are the same direction, and the second direction and the fifth direction are the same direction. Light (a laser beam) is emitted from the light-emitting element 20, which is a semiconductor laser element, with the fast axis direction of FFP being parallel with the fourth direction and the slow axis direction being parallel with the fifth direction. In this manner, the light-emitting device 1 can efficiently emit light.

In the light-emitting device 1, the light emitted from the light-emitting element 20 is incident on the flat surface region of the second surface 42E. The light of the main portion emitted from the light-emitting element 20 is incident on the flat surface region of the second surface 42E and is also incident on the curved surface region. Causing light to be incident on the flat surface region and the curved surface region allows the light to be efficiently incident on the second surface 42E, allowing efficient light emission.

In another configuration, the light of the main portion emitted from the light-emitting element 20 is incident on the flat surface region of the second surface 42E and is not incident on the curved surface region. When the curved surface region is not used, the direction of travel of light of the main portion incident on the second surface 42E can be controlled, and the color unevenness of the emitted light can be improved.

The length in the third direction of the phosphor member 40 is in a range from 1.2 times to 3 times the length in the third direction of the light incident on the second surface 42E. By setting the length to 1.2 times or greater, the upper end of the light incident surface and the light-emitting surface can be separated, and by setting the length to 3 times or less, the size of the phosphor member 40 can be reduced. When the phosphor member 40 is too short in the third direction, the light is not sufficiently diffused, and thus, in terms of luminance unevenness and color unevenness, the quality of the emitted light may be insufficient. On the other hand, when the phosphor member 40 is too long in the third direction, the extraction efficiency of the light emitted from the light-emitting surface may be diminished. By setting the length in the third direction of the phosphor member 40 within this range, light can be efficiently emitted.

The phosphor member 40 meets the third surface 42F and the second surface 42E, so that the second surface 42E forms a portion of the lower end of the outer edge of the phosphor member 40. With the light incident surface extending to the lower end of the phosphor member 40, the light from the light-emitting element 20 can be easily captured at the phosphor portion 41, allowing the light to be efficiently emitted.

On the other hand, the phosphor member 40 does not meet the first surface 42D and the second surface 42E and the light incident surface and the light-emitting surface are clearly separated by the surfaces 44 of the surrounding portion 43, the light-emitting member 40 can efficiently extract the light emitted from the light-emitting surface.

In the light-emitting device 1, the shape of the first surface 42D and the second surface 42E of the phosphor portion 41 satisfies the condition that the maximum width in the second direction of the first surface 42D is greater than the maximum width in the second direction of the second surface 42E. By designing the shape of the first surface 42D and the second surface 42E to satisfy this condition, the light-emitting device 1 provided can efficiently emit light.

The first side 441 of the phosphor member 40 is parallel with the second direction. The second side 442 of the phosphor member 40 is parallel with the first direction. The third side 443 of the phosphor member 40 is parallel with the first direction. The fourth side 444 of the phosphor member 40 is parallel with the second direction. Also, the term parallel used herein includes a tolerance of a difference of ±10 degrees.

In the phosphor member 40, the surrounding portion 43 impedes the light incident on the phosphor portion 41 or fluorescence from the phosphor portion 41 from being emitted outside of the light incident surface or the light-emitting surface. The surrounding portion 43 also functions as a light-reflective portion that reflects the light incident on the phosphor portion 41 or the fluorescence from the phosphor portion 41. In particular, the vicinity of the region that comes into contact with the surface of the phosphor portion 41 that is not exposed functions as a reflective region. For example, when the surrounding portion 43 is formed by sintering, a reflective function can be given by providing a gap in the vicinity of the region. Thus, the surrounding portion 43 being connected to the outer edge of the first surface 42D and the second surface 42E of the phosphor portion 41 may contribute to efficient emission of light from the light-emitting surface. In the light-emitting device 1, light from the light-emitting element 20 incident on the phosphor portion 41 or fluorescence from the phosphor portion 41 is reflected by the light-reflective portion (surrounding portion 43).

The light incident from the second surface 42E and that travels through the phosphor portion 41 is reflected at the vicinity of the inner surface 44D of the surrounding portion 43 that comes into contact with the fourth surface 42P, the fifth surface 42Q, the sixth surface 42R, and the seventh surface 42S. In this manner, by efficiently reflecting the light at the enclosed portion, light can be efficiently emitted from the light-emitting surface.

Furthermore, the phosphor portion 41 includes the second region 42N and the sixth surface 42R and seventh surface 42S that meet the outer edge of the second region 42N. Thus, the reflective function of the surrounding portion 43 that comes into contact with these surfaces 42 can be utilized, and light can be efficiently emitted from the light-emitting surface.

In the light-emitting device 1, the distance in the third direction from the upper end of the second surface 42E to the first surface 42D is less than the distance in the third direction from the upper end of the second surface 42E to the first mounting surface 141. By designing the shape of the phosphor member 40 to satisfy this condition, the light-emitting device 1 can efficiently emit light. Also, in the illustrated light-emitting device 1, the distance in the third direction from the upper end of the second surface 42E of the phosphor portion 41 to the first surface 42D is less than the length in the third direction of the second surface 42E.

In a top view, the width in the first direction of the phosphor member 40 is in a range from 10% to 50% of the width in the first direction of the frame of one or a plurality of inner surfaces of the frame portion 15. Also, in a top view, the maximum length (the length in the first direction between the point on the light-emitting element 20 farthest from the phosphor member 40 and the point on the phosphor member 40 farthest from the light-emitting element 20) in the first direction from the light-emitting element 20 to the phosphor member 40 is in a range from 50% to less than 100% of the width in the first direction of the frame of one or a plurality of inner surfaces of the frame portion 15. Reduction in size of the phosphor member 40 in the first direction in this manner allows for manufacturing the light-emitting device 1 of reduced size.

The virtual line connecting the intersection point of the first side 421 and the second side 422 of the phosphor member 40 and the intersection point of the third side 423 and the fourth side 424 is parallel with the optical axis of the light emitted from the light-emitting element 20. Further, in a top view, the virtual line and the optical axis of the light overlap. The term parallel used herein includes a tolerance of 10 degrees or less for the angle formed by the virtual line and the optical axis. In this manner, a long distance can be ensured from the light incident surface to the sixth surface 42R or the seventh surface 42S on a straight line overlapping the optical axis. Thus, the relative wavelength conversion efficiency to fluorescence is increased. Accordingly, the height of the phosphor portion 41 needed to obtain the necessary fluorescence can be low, allowing light to be efficiently emitted.

The wavelength range of the light transmitted by the light-controlling film 45 includes the light emission peak wavelength of the light emitted from the light-emitting element 20. The wavelength range of the light reflected by the light-controlling film 45 includes a peak wavelength of fluorescence from the phosphor portion 41. The light-controlling film 45 reflects, for example, 80% or greater of light in a wavelength range from 440 nm to 650 nm. The light-controlling film 45 is provided on the light incident surface of the phosphor member 40, and thus the light can be efficiently emitted.

The light-reflective film 46 reflects the light incident on the phosphor portion 41 from the light incident surface and fluorescence from the phosphor portion 41. By the light travelling downward being reflected upward, light can be efficiently emitted from the light-emitting surface.

### Manufacturing Method of Phosphor Member 40

Referring to FIGS. 12A to 12C, an example of the method of manufacturing the phosphor member 40 will be described. The phosphor member 40 can be manufactured by a manufacturing method including a plurality of steps. The plurality of steps include a step of preparing a base material 1A including the plurality of phosphor portions 41 (hereinafter, referred to as a first step), a step of cutting the base material 1A and providing the second surface 42E (hereinafter, referred to as a second step), and a step of singulating the base material 1A into the plurality of phosphor portions 41 (hereinafter, referred to as a third step). Furthermore, the plurality of steps may include a step of providing the light-controlling film 45 on the second surface 42E and a step of providing the light-reflective film 46 on the third surface 42F. Other steps may also be included.

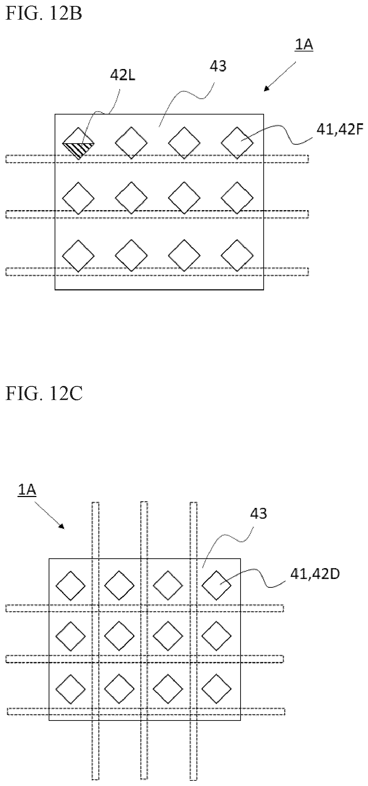

FIG. 12A is a schematic diagram of the base material 1A prepared in the first step. FIG. 12B is a schematic diagram illustrating how the base material 1A is cut to provide the second surface 42E in the second step. In FIG. 12B, the portion to be cut is marked with a broken line. FIG. 12C is a schematic diagram illustrating how the base material 1A is cut to singulate the base material 1A including the plurality of phosphor members 40 connected together into individual phosphor members 40 in the third step. In FIG. 12C, the portion to be cut is marked with a broken line.

The base material 1A prepared in the first step is the base material 1A provided with the plurality of phosphor portions 41 arranged separated from one another with the surrounding portion 43 surrounding all of the lateral surfaces of the plurality of phosphor portions 41 (see FIG. 12A). The plurality of phosphor portions 41 each have the shape of a quadrangular prism. In a top view, the plurality of phosphor portions 41 are arrayed such that the intersection points of the quadrilaterals of the adjacent phosphor portions 41 are closest to each other and the diagonal lines of the quadrilaterals are parallel.

In FIG. 12A, the plurality of phosphor portions 41 are arranged to be arrayed in the second direction. Additionally, the plurality of phosphor portions 41 arranged in the second direction are arranged in rows in the first direction. Additionally, the third surface 42F of each of the phosphor portions 41 opposes the upper surface.

In this manner, the base material 1A provided in the first step includes the plurality of phosphor portions 41 each including the third surface 42F with a shape including a third region 42L having a width in the second direction, perpendicular to the first direction, increasing along the first direction, and the surrounding portion 43 that surrounds the outer edge of the third surface 42F of each of the plurality of phosphor portions 41.

In the base material 1A prepared in the first step, each one of the plurality of phosphor portions 41 includes the first surface 42D with a shape including the first region 42M. The phosphor portions 41 of the base material 1A prepared in the first step do not include the second surface 42E.

In the second step, the base material 1A is cut in a direction from the third surface 42F toward the first surface 42D to a position that does not reach the first surface 42D along a straight line that, in a plan view viewed in a direction perpendicular to the third surface 42F, is parallel with the second direction and passes along a width in the second direction that is greater than the minimum width of the third region 42L in the second direction and less than the maximum width of the third region 42L in the second direction. This cutting forms the second surface 42E of each of the plurality of phosphor portions 41. Additionally, the fifth side 425 of the third surface 42F is formed by this cutting.

In the second step, the plurality of phosphor portions 41 arranged to be arrayed in the second direction are collectively cut. In the first step, the intersection points of the plurality of phosphor portions 41 oppose one another, allowing for the plurality of phosphor portions 41 to be collectively cut.

In the third step, from among the phosphor portions 41 and the surrounding portion 43 that form the base material 1A, only the surrounding portion 43 is cut and singulated into the plurality of phosphor portions 41. By cutting the surrounding portion 43 in the vertical direction, it is singulated into the plurality of phosphor portions 41. Also, each of the singulated phosphor portions 41 is connected to the surrounding portion 43 including the second surface 44F and the fourth surface 44H.

In the third step, only the surrounding portion 43 of the base material 1Ais cut and singulated into each one of the plurality of phosphor members 40 including the first surface 42D, the second surface 42E, and the third surface 42F. In each one of the phosphor portions 41 singulated by the singulation of the plurality of phosphor members 40, the first surface 42D, the second surface 42E, and the third surface 42F are exposed, and the other surfaces 42 are covered by the surrounding portion 43. Additionally, the fourth surface 44H of the surrounding portion 43 is formed by this cutting. In this manner, each one of the plurality of phosphor portions 41 is singulated into a part of the plurality of phosphor members 40.

The cutting in the second step and the cutting in the third step can be performed using the same dicing device. In the second step, the dicing device is controlled until before it cuts all the way through, and in the third step, the dicing device is controlled to cut all the way through. In the second step and the third step, the cut and the cut all the way through are both linear cuts, and thus the phosphor members 40 can be easily manufactured.

### Second Embodiment

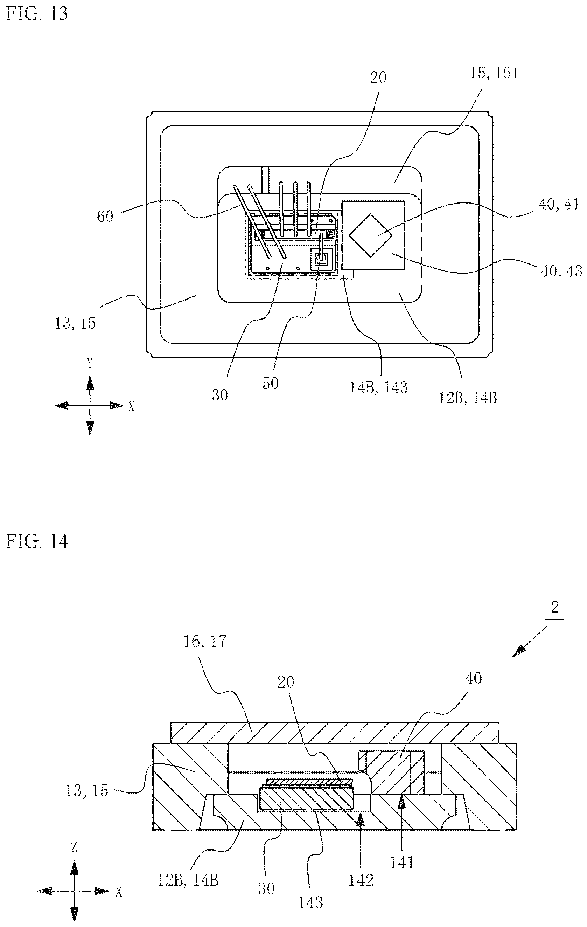

A light-emitting device 2 according to the second embodiment will now be described. The light-emitting device 2 differs from the first embodiment in terms of the shape of the package. FIGS. 13 and 14 are diagrams for explaining an exemplary form of the configuration of the light-emitting device 2. Further, FIGS. 1 and 5 to 12C are also diagrams for describing the light-emitting device 2. FIG. 13 is a schematic top view of the light-emitting device 2, in a state in which the cover member 16 is removed. FIG. 14 is a cross-sectional view taken along cross section line XIV-XIV in FIG. 1.

The light-emitting device 2 includes a plurality of components. The plurality of components include a package 10B, the light-emitting element 20, the submount 30, the phosphor member 40, the protective element 50, and the plurality of wirings 60. Also, the package 10B includes a base portion 14B. The package 10B also includes a base member 11B.

All descriptions related to the light-emitting device 1 and the components of the first embodiment described above apply to the description of the light-emitting device 2 except for the contents that can be said to be inconsistent from the diagrams of FIGS. 1 and 5 to 14 according to the light-emitting device 2. All contents not inconsistent will not be described again in order to avoid duplication.

Further, descriptions relating to the package 10A of the first embodiment are also applicable to the description of the package 10B except for the contents that are inconsistent from the diagrams according to the package 10B of the second embodiment. Note that the package 10A, the base member 11A, the mounting substrate 12A, and the base portion 14Ain the first embodiment each correspond to the package 10B, the base member 11B, a mounting substrate 12B, and the base 14B in the second embodiment.

### Package 10B

In the package 10B, the base portion 14B includes a second mounting surface 142. The second mounting surface 142 is provided at a position lower than the first mounting surface 141. The second mounting surface 142 is surrounded by the first mounting surface 141 in a top view. In the base portion 14B, a recessed portion 143 surrounded by the first mounting surface 141 is formed.

### Light-Emitting Device 2

In the light-emitting device 2, the phosphor member 40 is disposed on the first mounting surface 141, and the light-emitting element 20 is disposed on the second mounting surface 142. Accordingly, compared to the light-emitting device 1 of the first embodiment, the light emission point of the light emitted from the light-emitting element 20 toward the phosphor member 40 can be provided at a lower position. When the distance from the light emission point to the light-reflective film 46 is decreased, the area of the light incident surface can be made relatively small and the light can be efficiently emitted.

Although each of the embodiments according to the present invention has been described above, the light-emitting device according to the present invention is not strictly limited to the light-emitting device in each of the embodiments. In other words, the present invention can be achieved without being limited to the external shape or structure of the light-emitting device disclosed by each of the embodiments. The present invention may be applied without requiring all the components being sufficiently provided. For example, in a case in which some of the components of the light-emitting device disclosed by the embodiments are not stated in the scope of the claims, the degree of freedom in design by those skilled in the art such as substitutions, omissions, shape modifications, and material changes for those components is allowed, and then the invention stated in the scope of the claims being applied to those components is specified.

The light-emitting device according to each of the embodiments can be used for an illumination device such as a smart light or indirect lighting, a vehicle headlight, a headmounted display, a projector, a display, and the like.

## Claims

1. A phosphor member comprising:
a phosphor portion including a first surface and a second surface; and
a surrounding portion connected to an outer edge of the first surface and connected to an outer edge of the second surface, wherein:
in a plan view viewed in a direction perpendicular to the first surface, the first surface has a shape including a first region with a width in a second direction perpendicular to a first direction, the width in the second direction increasing along the first direction, and
a maximum width of the second surface in the second direction is greater than a minimum width of the first surface in the second direction and less than a maximum width of the first surface in the second direction.

2. The phosphor member according to claim 1, wherein:
in a plan view viewed in a direction perpendicular to the first surface, the second surface is located inside the first region.

3. The phosphor member according to claim 1 or 2, wherein:
the second surface is not parallel with the first surface.

4. The phosphor member according to any one of claims 1 to 3, wherein:
a maximum width of the second surface in a third direction perpendicular to both the first direction and the second direction is greater than a maximum width of the second surface in the second direction.

5. The phosphor member according to any one of claims 1 to 4, wherein:
the phosphor portion includes a third surface opposite to the first surface, and
an area of the third surface is smaller than an area of the first surface.

6. The phosphor member according to claim 5, wherein:
the first surface includes a first side and a second side that form the first region, and
in a plan view viewed in a direction perpendicular to the first surface, the third surface includes:
a side that partially overlaps the first side,
a side that partially overlaps the second side, and
a side that overlaps a straight line connecting an intermediate point of the first side and an intermediate point of the second side.

7. The phosphor member according to claim 5 or 6, wherein:
the second surface meets the third surface and does not meet the first surface.

8. The phosphor member according to any one of claims 5 to 7, wherein:
in a plan view viewed in a direction perpendicular to the first surface, an outer perimeter of a shape of the third surface is located inward of an outer perimeter of a shape of the first surface, and
in a plan view viewed in a direction perpendicular to the first surface, the first region includes:
a region overlapping the third surface and
a region overlapping the second surface and not overlapping the third surface.

9. The phosphor member according to any one of claims 1 to 5, wherein:
in a plan view perpendicular to the first surface, the first surface includes:
a first side and a second side that form the first region, and
a third side and a fourth side that form a second region, the second region having a width in the second direction that decreases in the first direction, and
in a plan view viewed in a direction perpendicular to the first surface, the second surface is located inside the first surface, overlaps the first region, and does not overlap the second region.

10. The phosphor member according to any one of claims 1 to 9, wherein:
the first surface has a quadrangular shape.

11. A light-emitting device according to any one of claims 1 to 10, comprising:
a light-emitting element;
the phosphor member according to any one of claims 1 to 10; and
a package forming an internal space where the light-emitting element and the phosphor member are disposed, wherein:
light emitted from the light-emitting element is incident on the second surface of the phosphor member, and
light emitted from the first surface of the phosphor member is emitted toward an outside of the package.

12. The light-emitting device according to claim 11, wherein:
the phosphor member is disposed at a forward position in the first direction with respect to the light-emitting element.

13. The light-emitting device according to claim 11 or 12, wherein:
the light-emitting element is configured to emit light with a shape that, in a plan view viewed in a direction perpendicular to the first direction, is longer in a direction perpendicular to both the first direction and the second direction than in the second direction.

14. A method of manufacturing a phosphor member including a first surface, a second surface, and a third surface opposite to the first surface, the method comprising:
providing a base material comprising:
a plurality of phosphor portions, each comprising the third surface with a shape including a region having a width in a second direction perpendicular to a first direction, the width in the second direction increasing along the first direction, and
a surrounding portion that surrounds an outer perimeter of the third surface of each of the plurality of phosphor portions;
cutting the base material in a direction from the third surface toward the first surface to a position that does not reach the first surface, the cutting performed, in a plan view viewed in a direction perpendicular to the third surface, along a straight line that is parallel with the second direction and passes along a width of the region in the second direction greater than a minimum width of the region in the second direction and less than a maximum width of the region in the second direction, to obtain the second surface of each of the plurality of phosphor portions; and
cutting only the surrounding portion of the base material to singulate the plurality of phosphor portions.

15. The manufacturing method according to claim 14, wherein:
in the step of providing the base material, the plurality of phosphor portions each comprise the first surface having a shape comprising a region having a width in a second direction perpendicular to a first direction, the width in the second direction increasing along the first direction, and
in the step of singulating the plurality of phosphor portions, only the surrounding portion of the base material is cut to be singulated into a plurality of phosphor members each comprising the first surface, the second surface, and the third surface.
